## Europäisches Patentamt

## European Patent Office

## Office européen des brevets

(19)

(11) Veröffentlichungsnummer: **0 129 644**
**B1**

(12)

# EUROPÄISCHE PATENTSCHRIFT

(45) Veröffentlichungstag der Patentschrift:
24.06.87

(51) Int. Cl.⁴: **H 03 F 3/45**

(21) Anmeldenummer: **84103096.8**

(22) Anmeldetag: **21.03.84**

(54) **Verstärker mit niedriger Offset-Spannung.**

(30) Priorität: **08.06.83 CH 3137/83**

(43) Veröffentlichungstag der Anmeldung:
**02.01.85 Patentblatt 85/1**

(45) Bekanntmachung des Hinweises auf die Patenterteilung:
**24.06.87 Patentblatt 87/26**

(84) Benannte Vertragsstaaten:
**DE FR**

(56) Entgegenhaltungen:
**DE - A - 2 506 162**
**DE - A - 2 825 882**
**FR - A - 2 316 788**

**WESCON CONFERENCE RECORD, 16.-18. September 1980, Band 24, Seiten 26/1-1 bis 26/1-14, Anaheim, CA., US; D. BINGHAM: "Analog circuit performance improves with MOS/CMOS TECHNIQUES"**

(73) Patentinhaber: **LGZ LANDIS & GYR ZUG AG,**
**CH-6301 Zug (CH)**

(72) Erfinder: **de Vries, Jacob, Feldbergstrasse 2,**
**CH-6311 Allenwinden (CH)**

(74) Vertreter: **Müller, Hans-Jürgen, Dipl.-Ing., Müller,**
**Schupfner & Gauger**
**Lucile-Grahn-Strasse 38 Postfach 80 13 69,**
**D-8000 München 80 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Anwendungsgebiet und Zweck

Die Erfindung bezieht sich auf einen Verstärker mit niedriger Offset-Spannung gemäss dem Oberbegriff des Anspruches 1.

Solche Verstärker dienen der kontinuierlichen Verstärkung von Signalen mit möglichst niedrigem Offsetfehler, der hauptsächlich verursacht wird durch ungleiche Eingangsstufen des Verstärkers. Dieser wird z.B. in Analog/Digital-Wandler verwendet.

Stand der Technik

Aus der DE-OS 28 25 882 ist ein offsetkompensierter Verstärker bekannt, bestehend aus zwei Operationsverstärkern mit je einem zugehörigen Kompensations-Kondensator. Jeder Operationsverstärker arbeitet abwechselnd in einer «Autozero»- und in einer Verstärkungs-Phase, wobei während der ersteren der zugehörige Kompensations-Kondensator auf die Offset-Spannung geladen wird.

Aufgabe der Lösung

Der Erfindung liegt die Aufgabe zugrunde, bei einem offsetkompensierten Verstärker der eingangs genannten Art die Umschaltspitzen zu verkleinern, die beim Wechseln von der «Autozero»- auf die Verstärkungs-Phase durch kurzzeitiges Öffnen des Signalpfades entstehen. Solche Umschaltspitzen sind für Messzwecke höchst unerwünscht. Ausserdem soll jeder Kompensations-Kondensator einpolig geerdet und die Schaltung des Verstärkers möglichst geeignet sein zur Vollintegration in der Silizium-Gate-CMOS-Technologie.

Die genannte Aufgabe wird erfindungsgemäss durch die im Kennzeichen des Patentanspruches 1 angegebenen Merkmale gelöst.

Ein Ausführungsbeispiel der Erfindung ist in der Zeichnung dargestellt und wird im folgenden näher beschrieben.

Es zeigen:

Fig. 1 ein Schaltbild eines Verstärkers mit niedriger Offset-Spannung,

Fig. 2 ein Zeitdiagramm des Steuersignals $U_{s,1}$ eines ersten Schalters,

Fig. 3 ein Zeitdiagramm des Steuersignals $U_{s,2}$ eines zweiten Schalters,

Fig. 4 ein Zeitdiagramm des Steuersignals $U_{S,3}$ eines dritten Schalters,

Fig. 5 ein Zeitdiagramm des Steuersignals $U_{S,4}$ eines vierten Schalters,

Fig. 6 ein Zeitdiagramm des Steuersignals $U_{S,5}$ eines fünften Schalters,

Fig. 7 ein Zeitdiagramm des Steuersignals $U_{S,6}$ eines sechsten Schalters,

Fig. 8 ein Schaltbild mit einem ersten Operationsverstärker in der «Autozero»-Phase,

Fig. 9 ein Schaltbild mit dem ersten Operationsverstärker in der Vorbereitungsphase,

Fig. 10 ein Schaltbild mit dem ersten Operationsverstärker in der Verstärkungsphase,

Fig. 11 ein Schaltbild einer Steuerschaltung und

Fig. 12 ein Schaltbild der Eingangsstufe eines Operationsverstärkers mit zwei invertierenden und zwei nichtinvertierenden Eingängen.

Gleiche Bezugszahlen bezeichnen in allen Figuren der Zeichnung gleiche Teile.

Beschreibung

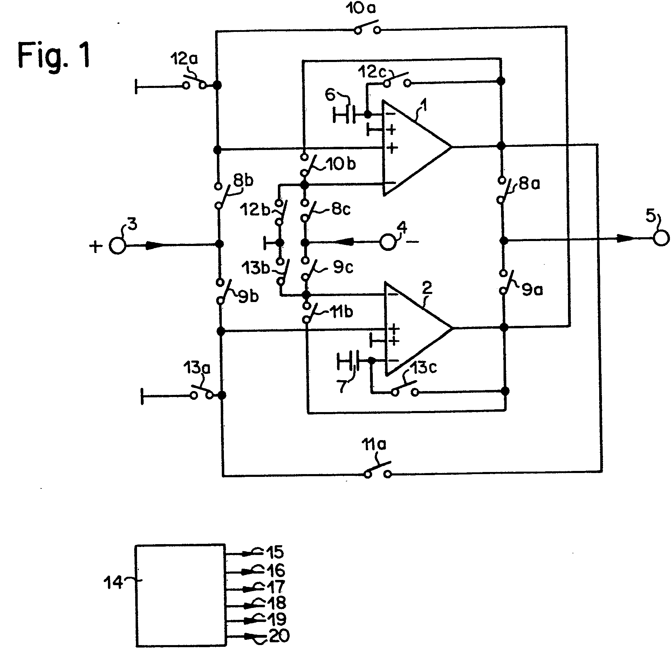

Der Verstärker der Fig. 1 besteht aus
– einem ersten Operationsverstärker 1,
– einem zweiten Operationsverstärker 2,
– einem nichtinvertierenden Verstärkereingang 3,
– einem invertierenden Verstärkereingang 4,
– einem Verstärkerausgang 5,
– einem ersten Kondensator 6,
– einem zweiten Kondensator 7,
– einem ersten Pol 8a eines dreipoligen ersten Schalters 8,
– einem zweiten Pol 8b des dreipoligen ersten Schalters, 8
– einem dritten Pol 8c des dreipoligen ersten Schalters 8,
– einem ersten Pol 9a eines dreipoligen zweiten Schalters 9,
– einem zweiten Pol 9b des dreipoligen zweiten Schalters 9,
– einem dritten Pol 9c des dreipoligen zweiten Schalters 9,
– einem ersten Pol 10a eines zweipoligen dritten Schalters 10,
– einem zweiten Pol 10b des zweipoligen dritten Schalters 10,
– einem ersten Pol 11a eines zweipoligen vierten Schalters 11,
– einem zweiten Pol 11b des zweipoligen vierten Schalters 11,
– einem ersten Pol 12a eines dreipoligen fünften Schalters 12,
– einem zweiten Pol 12b des dreipoligen fünften Schalters 12,
– einem dritten Pol 12c des dreipoligen fünften Schalters 12,
– einem ersten Pol 13a eines dreipoligen sechsten Schalters 13,
– einem zweiten Pol 13b des dreipoligen sechsten Schalters 13,
– einem dritten Pol 13c des dreipoligen sechsten Schalters 13 und
– einer Steuerschaltung 14.

Die Ausgänge der beiden Operationsverstärker 1 und 2 sind jeweils über einen ersten Pol 8a bzw. 9a eines ersten bzw. zweiten Schalters mit dem Verstärkerausgang 5 verbunden. Die beiden Operationsverstärker 1 und 2 besitzen je einen ersten und zweiten nichtinvertierenden sowie je einen ersten und zweiten invertierenden Eingang, wobei die ersten nichtinvertierenden Eingänge jeweils über den zweiten Pol 8b bzw. 9b des ersten bzw. zweiten Schalters mit dem nichtinvertierenden Verstärkereingang 3, über den ersten Pol 10a bzw. 11a des dritten bzw. vierten Schalters mit dem Ausgang des anderen Operationsverstärkers 2 bzw. 1 und über den ersten Pol 12a bzw. 13a des fünften bzw. sechsten Schalters mit Masse verbunden sind. Die ersten invertierenden Eingänge der beiden Operationsverstärker 1 und 2 sind jeweils über den dritten Pol 8c bzw. 9c des ersten bzw. zweiten Schalters mit dem invertierenden Verstärkereingang 4 und über den zweiten Pol 10b bzw. 11b des dritten bzw. vierten Schalters mit dem Ausgang des zugehörigen Operationsverstärkers sowie über den zweiten Pol 12b bzw. 13b des fünften bzw. sechsten Schalters mit Masse verbunden. Der zweite nichtinvertierende Eingang der Operationsverstärker 1, 2 liegt direkt und der zweite invertierende Eingang jeweils über den ersten bzw. zweiten Kondensator 6 bzw. 7 ebenfalls an Masse. Der zweite invertierende Eingang ist zusätzlich jeweils über den dritten Pol 12c bzw. 13c des fünften bzw. sechsten Schalters mit dem Ausgang des zugehörigen Operationsverstärkers 1 bzw. 3 verbunden.

Die Schalter sind alle z.B. Analogschalter und jeder wird von einem einzigen der sechs Ausgänge der Steuerschaltung 14 gesteuert. Der erste Ausgang 15 dieser Steuerschaltung 14 ist mit dem Steuereingang des ersten Schalters 8, der zweite Ausgang 16 mit dem Steuereingang des zweiten Schalters 9, der dritte Ausgang 17 mit dem Steuereingang des dritten Schalters 10, der vierte Ausgang 18 mit dem Steuereingang des vierten Schalters 11, der fünfte Ausgang 19 mit dem Steuereingang des fünften Schalters 12, und der sechste Ausgang 20 mit dem Steuereingang des sechsten Schalters 13 verbunden. Diese Verbindungen zwischen der Steuerschaltung 14 und den sechs Schaltern 8, 9, 10, 11, 12 und 13 sind in der Fig. 1 aus Gründen der zeichnerischen Klarheit nicht dargestellt.

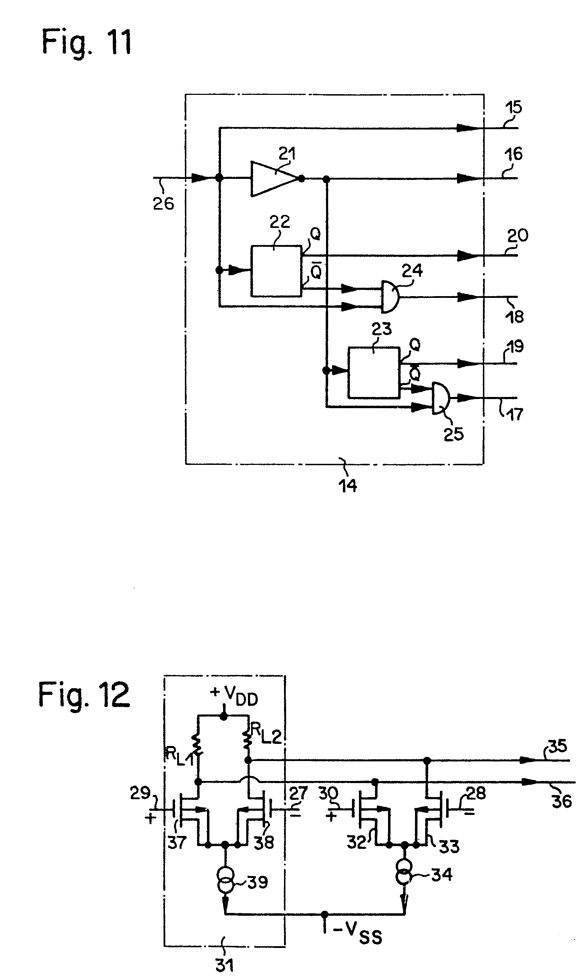

Die Steuerschaltung 14 gemäss der Fig. 11 besteht aus
- einem Inverter 21,
- einem ersten monostabilen Multivibrator 22,
- einem zweiten monostabilen Multivibrator 23,
- einem ersten Und-Gatter 24 und
- einem zweiten Und-Gatter 25.

Ein Takteingang 26 der Steuerschaltung 14 erreicht direkt den ersten Ausgang 15 und über den Inverter 21 den zweiten Ausgang 16 der Steuerschaltung 14. Er speist gleichzeitig den mittels positiv gehender Flanken gesteuerten Eingang des ersten monostabilen Multivibrators 22 und einen ersten Eingang des ersten Und-Gatters 24, dessen zweiter Eingang am Q̄-Ausgang des ersten monostabilen Multivibrators 22 liegt. Der Q-Ausgang des letzteren bildet den sechsten Ausgang 20 und der Ausgang des ersten Und-Gatters 24 den vierten Ausgang 18 der Steuerschaltung 14. Der zweite Ausgang 16 der Steuerschaltung 14 ist mit dem mittels positiv gehender Flanken gesteuerten Eingang des zweiten monostabilen Multivibrators 23 und mit einem ersten Eingang des zweiten Und-Gatters 25 verbunden, dessen zweiter Eingang am Q̄-Ausgang des zweiten monostabilen Multivibrators 23 liegt. Der Q-Ausgang des letzteren bildet den fünften Ausgang 19 und der Ausgang des zweiten Und-Gatters 25 den dritten Ausgang 17 der Steuerschaltung 14.

Die in der Fig. 12 dargestellte Eingangsstufe eines Operationsverstärkers mit zwei invertierenden Eingängen 27 und 28 und zwei nichtinvertierenden Eingängen 29 und 30 entspricht der normalen differentiellen Eingangsstufe 31 aus MOS-Transistoren eines Operationsverstärkers, welche erweitert wurde durch zwei zusätzliche MOS-Transistoren 32 und 33 sowie durch eine zusätzliche Stromquelle 34. Der zweipolige Ausgang der Eingangsstufe 31 ist gleichzeitig der zweipolige Ausgang 35; 36 der erweiterten Eingangsstufe. Die Eingangsstufe 31 besteht aus einem ersten MOS-Transistor 37, einem zweiten MOS-Transistor 38, einer ersten Stromquelle 39, einem ersten Lastwiderstand $R_{L1}$ und einem zweiten Lastwiderstand $R_{L2}$. Eine positive Speisespannung $+V_{DD}$ speist einerseits über den ersten Lastwiderstand $R_{L1}$ die Drain des ersten MOS-Transistors 37 und die Drain des ersten zusätzlichen MOS-Transistors 32 und anderseits über den zweiten Lastwiderstand $R_{L2}$ die Drain des zweiten MOS-Transistors 38 und die Drain des zweiten zusätzlichen MOS-Transistors 33. Das Substrat und die Source der beiden MOS-Transistoren 37 und 38 sind miteinander und mit einem ersten Pol der ersten Stromquelle 39 verbunden. Das gleiche gilt für das Substrat und die Source der beiden zusätzlichen MOS-Transistoren 32 und 33 und einem ersten Pol der zweiten Stromquelle 34. Der zweite Pol der beiden Stromquellen 34 und 39 ist mit einer negativen Speisespannung $-V_{SS}$ verbunden. Die Gate der vier Transistoren 37, 38, 32 und 33 bilden die vier Eingänge 29, 27, 30 und 28 der erweiterten Eingangsstufe, während die je zwei und zwei miteinander verbundenen Drain dieser MOS-Transistoren den zweipoligen Ausgang 35; 36 der erweiterten Eingangsstufe bilden. Aus dem Aufbau der Eingangsstufe ist leicht ersichtlich, dass die Ausgangsspannung $U_{out}$ derselben gleich $K_1(U_{29}-U_{27}) + K_2(U_{30}-U_{28})$ ist, wobei $K_1$ den Verstärkungsfaktor der Eingangsstufe 31 und $K_2$ denjenigen der aus den beiden zusätzlichen MOS-Transistoren 32 und 33 gebildeten Eingangsstufe darstellt. $U_j$ ist mit $j = 29$, 30, 27, 28 die Eingangsspannung am Eingang j.

Funktionsbeschreibung

Jeder der beiden Operationsverstärker 1, 2 arbeitet nichtüberlappend zeitlich nacheinander und in der angegebenen Reihenfolge in einer «Autozero»-Phase $A_1$ bzw. $A_2$, in einer Vorbereitungs-Phase $B_1$ bzw. $B_2$ und in einer Verstärkungs-Phase $C_1$ bzw. $C_2$. Der Index 1 bezieht sich dabei auf den ersten Operationsverstärker 1 und der Index 2 auf den zweiten Operationsverstärker 2.

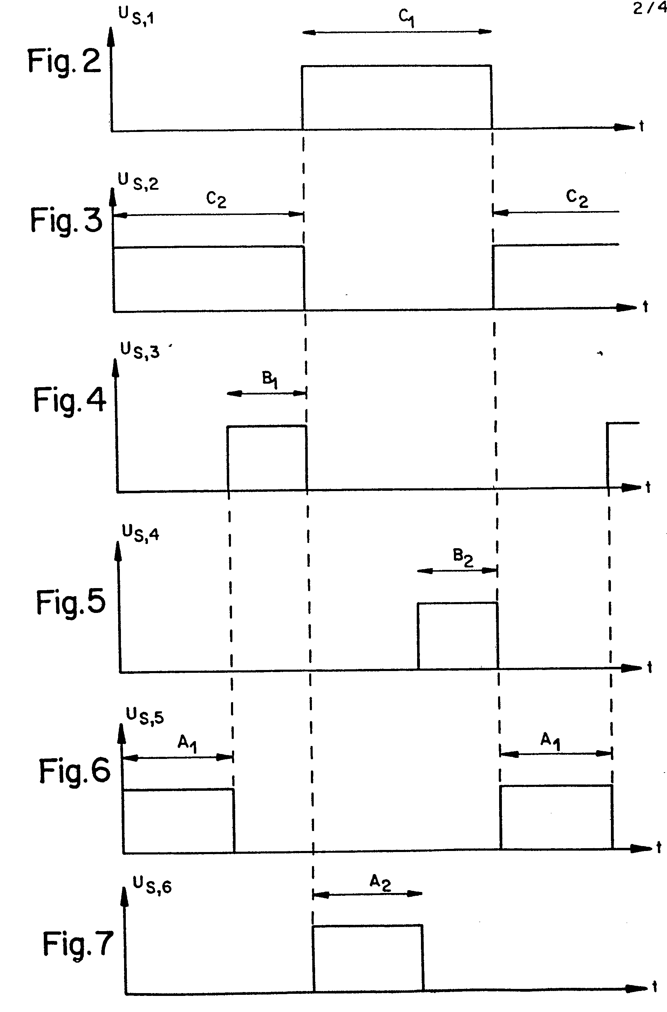

Die Verstärkungs-Phasen der beiden Operationsverstärker 1, 2 befinden sich gemäss den Figuren 2 und 3 im Gegentakt zueinander, und während der eine Operationsverstärker sich in der Verstärkungs-Phase befindet, arbeitet der andere in einer der beiden anderen Phasen gemäss der Fig. 4, der Fig. 5, der Fig. 6 und der Fig. 7. In diesen anderen Phasen arbeitet der betreffende Operationsverstärker 1 bzw. 2 als klassischer nichtinvertierender Verstärker mit dem Verstärkungsfaktor Eins. In der «Autozero»-Phase wird der zum betreffenden Operationsverstärker 1 bzw. 2 gehörige Kondensator 6 bzw. 7 auf die Offset-Spannung des betreffenden Operationsverstärkers geladen. In der Verstärkungs-Phase arbeitet der betreffende Operationsverstärker 1 bzw. 2 als Differenzverstärker und verstärkt die Spannung des Verstärkereingangs 3; 4 minus der im zugehörigen Kondensator 6 bzw. 7 gespeicherten Spannung. Letztere ist in der Regel gleich der Offset-Spannung des betreffenden Operationsverstärkers 1 bzw. 2. Die beiden Kondensatoren 6, 7 arbeiten somit als Kompensations-Kondensatoren zum Kompensieren der Offset-Spannungen der Operationsverstärker 1, 2. Die Dauer der «Autozero»-Phase ist so gewählt, dass die beiden Kondensatoren 6, 7 genügend Zeit haben, sich auf die volle Offset-Spannung aufzuladen. Die Dauer der gleichnamigen Phasen sind vorteilhaft alle gleich. Wie aus den Figuren 2 bis 7 ersichtlich, sind folgende vier Kombinationen möglich:

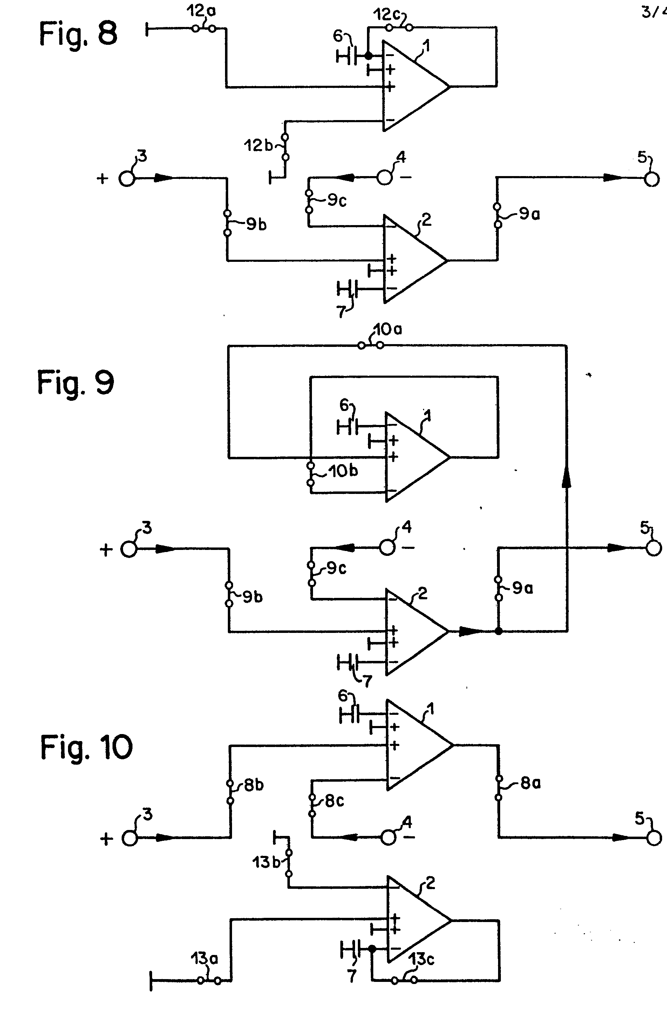

– Der erste Operationsverstärker 1 befindet sich in der «Autozero»-Phase A$_1$, d.h. der fünfte Schalter 12 ist geschlossen, und der zweite Operationsverstärker 2 arbeitet in der Verstärkungs-Phase C$_2$, d.h., der zweite Schalter 9 ist geschlossen. Dieser Fall ist in der Fig. 8 dargestellt.

– Der erste Operationsverstärker 1 befindet sich in der Vorbereitungs-Phase B$_1$, d.h., der dritte Schalter 10 ist geschlossen, und der zweite Operationsverstärker 2 arbeitet in der Verstärkungs-Phase C$_2$, d.h. der zweite Schalter 9 ist geschlossen. Dieser Fall ist in der Fig. 9 dargestellt.

– Der erste Operationsverstärker 1 befindet sich in der Verstärkungs-Phase C$_1$, d.h. der erste Schalter 8 ist geschlossen, und der zweite Operationsverstärker 2 arbeitet in der «Autozero»-Phase A$_2$, d.h. der sechste Schalter 13 ist geschlossen. Dieser Fall ist in der Fig. 10 dargestellt.

– Der erste Operationsverstärker 1 befindet sich in der Verstärkungs-Phase C$_1$, d.h. der erste Schalter 8 ist geschlossen, und der zweite Operationsverstärker 2 arbeitet in der Vorbereitungs-Phase B$_2$, d.h. der vierte Schalter 11 ist geschlossen.

In den Figuren 8 bis 10 wurden aus Gründen der Übersicht alle diejenigen Leitungen, die einen offenen Schalter besitzen, nicht gezeichnet.

In der Fig. 8 sind nur der zweite und der fünfte Schalter 9 und 12 geschlossen. Beide Operationsverstärker 1, 2 arbeiten unabhängig voneinander. Da die Eingangsspannungen des ersten Operationsverstärkers 1 Null sind, ist in ihm nur eine Offset-Spannung wirksam, und da der Verstärkungsfaktor Eins ist, erscheint die Offset-Spannung ebenfalls am Ausgang des ersten Operationsverstärkers 1 und lädt den ersten Kondensator 6 auf diese Offset-Spannung auf.

Sobald die «Autozero»-Phase A$_1$ des ersten Operationsverstärkers 1 beendet ist, beginnt seine Vorbereitungs-Phase B$_1$: Der fünfte Schalter 12 wird geöffnet und statt dessen der dritte Schalter 10 geschlossen (siehe Fig. 9). Am Betrieb des zweiten Operationsverstärkers 2 ändert sich nichts, nur sein Ausgang speist nun einen der Eingänge des ersten Operationsverstärkers 1, wo diese Spannung minus der im ersten Kondensator 6 geladenen Offset-Spannung des ersten Operationsverstärkers 1 um den Verstärkungsfaktor Eins verstärkt an dessen Ausgang erscheint. Diese Ausgangsspannung des ersten Operationsverstärkers 1 ist somit gleich der verstärkten, am Verstärkereingang 3; 4 anstehenden Eingangsspannung, die um die Wirkung der in den beiden Kondensatoren 6, 7 geladenen Offset-Spannungen der beiden Operationsverstärker 1, 2 reduziert ist. Die Ausgangsspannung des ersten Operationsverstärkers 1 ist somit die um die beiden Offset-Spannungen kompensierte Ausgangsspannung des Gesamtverstärkers. Sie wird jedoch in der Vorbereitungs-Phase B$_1$ noch nicht auf dessen Ausgang 5 geschaltet. Dies geschieht erst zu Beginn der nachfolgenden Verstärkungs-Phase C$_1$ unter gleichzeitiger Abtrennung des zweiten Operationsverstärkers 2 vom Verstärkerausgang 5. Der bei diesem Umschalten entstehende Spannungssprung am Verstärkerausgang 5 ist gleich der kleinen Offset-Spannung des ersten Operationsverstärkers 1 und kann gegenüber dem Wert dieser Ausgangsspannung vernachlässigt werden. Das Vorhandensein der Vorbereitungsphase verhindert somit das Entstehen von grossen Schaltspitzen und diese wurden somit minimiert.

In der Fig. 10 sind nur der erste und der sechste Schalter 8 und 13 geschlossen. Diesmal arbeitet der zweite Operationsverstärker 2 in der «Autozero»-Phase A$_2$ und der zweite Kondensator 7 wird auf die Offset-Spannung dieses zweiten Operationsverstärkers 2 geladen. Der Zyklus beginnt aufs neue mit vertauschten Rollen der beiden Operationsverstärker 1, 2.

In der Fig. 11 wird der Takteingang 26 von einem Taktsignal gespeist, dessen halbe Periode gleich der Dauer der Verstärkungs-Phase C$_1$ bzw. C$_2$ ist. Die Impulsdauer der beiden monostabilen Multivibratoren 22 und 23 sind gleich der Dauer der «Autozero»-Phase A$_2$ bzw. A$_1$. Der erste monostabile Multivibrator 22 wird von der positiv gehenden Flanke des Taktsignals und der zweite monostabile Multivibrator 23 über den Inverter 21 von der negativ gehenden Flanke des Taktsignals gestartet.

Sobald der monostabile Multivibrator 22 bzw. 23 in die Ruhelage zurückkehrt, ist die zugehörige «Autozero»-Phase beendet und es erscheint ein Binärwert «1» an dessen $\overline{Q}$-Ausgang, der das nachfolgende erste bzw. zweite Und-Gatter 24 bzw. 25 für die Dauer der Vorbereitungs-Phase freigibt. Diese wird beendet mit Beginn der nachfolgenden Verstärkungs-Phase durch Sperrung des betreffenden Und-Gatters 24 bzw. 25 über dessen anderen, nämlich ersten Eingang. Am ersten Ausgang 15 der Steuerschaltung 14 erscheint ein Steuersignal U$_{s,1}$ gemäss der Fig. 2, am zweiten Ausgang 16 ein Steuersignal U$_{s,2}$ gemäss der Fig. 3, am dritten Ausgang 17 ein Steuersignal U$_{s,3}$ gemäss der Fig. 4, am vierten Ausgang 18 ein Steuersignal U$_{s,4}$ gemäss der Fig. 5, am fünften Ausgang 19 ein Steuersignal $U_{S,5}$ gemäss der Fig. 6 und am sechsten Ausgang 20 ein Steuersignal $U_{S,6}$ gemäss der Fig. 7.

## Patentanspruch

1. Verstärker mit niedriger Offset-Spannung, mehrere Schalter, eine Steuerschaltung zu deren Steuerung sowie zwei Operationsverstärker enthaltend, deren Ausgänge jeweils über einen ersten Pol eines ersten bzw. zweiten Schalters mit dem Verstärkerausgang verbunden sind, wobei die beiden Operationsverstärker (1, 2) sich abwechselnd und in Gegentakt zueinander in einer «Autozero»-Phase ($A_1$ bzw. $A_2$) oder in einer Verstärkungs-Phase ($C_1$ bzw. $C_2$) befinden, dadurch gekennzeichnet, dass die Operationsverstärker (1, 2) je einen ersten und zweiten nichtinvertierenden sowie je einen ersten und zweiten invertierenden Eingang besitzen und dass sich jeder der beiden Operationsverstärker (1 bzw. 2) anschliessend an seine «Autozero»-Phase ($A_1$ bzw. $A_2$) und vor Beginn seiner Verstärkungs-Phase ($C_1$ bzw. $C_2$) noch zusätzlich nichtüberlappend in einer Vorbereitungs-Phase ($B_1$ bzw. $B_2$) befindet, dass die ersten nichtinvertierenden Eingänge jeweils über einen zweiten Pol (8b bzw. 9b) des ersten bzw. zweiten Schalters mit dem nichtinvertierenden Verstärkereingang (3), über einen ersten Pol (10a bzw. 10b) eines dritten bzw. vierten Schalters mit dem Ausgang des anderen Operationsverstärkers (2 bzw. 1) und über einen ersten Pol (12a bzw. 13a) eines fünften bzw. sechsten Schalters mit Masse verbunden sind, und die ersten invertierenden Eingänge jeweils über einen dritten Pol (8c bzw. 9c) des ersten bzw. zweiten Schalters mit dem invertierenden Verstärkereingang (4), über einen zweiten Pol (10b bzw. 11b) des dritten bzw. vierten Schalters mit dem Ausgang des zugehörigen Operationsverstärkers (1 bzw. 2) und über einen zweiten Pol (12b bzw. 13b) des fünften bzw. sechsten Schalters mit Masse verbunden sind, dass der zweite invertierende Eingang jeweils über einen dritten Pol (12c bzw. 13c) des fünften bzw. sechsten Schalters mit dem Ausgang des zugehörigen Operationsverstärkers (1 bzw. 2) verbunden ist, und er über einen dem Operationsverstärker (1 bzw. 2) zugehörigen Kondensator (6 bzw. 7) an Masse liegt, während der zweite nichtinvertierende Eingang jeweils direkt an Masse liegt, wobei zeitlich nacheinander in der nachfolgend angegebenen Reihenfolge entweder nur der zweite und fünfte Schalter (9, 12), der zweite und dritte Schalter (9, 10), der erste und sechste Schalter (8, 13) oder der erste und vierte Schalter (8, 11) geschlossen sind.

## Revendication

1. Amplificateur ayant une faible tension de décalage et comportant plusieurs interrupteurs, un circuit de commande pour assurer sa commande ainsi que deux amplificateurs opérationnels, dont les sorties sont respectivement reliées par l'intermédiaire d'un premier pôle d'un premier ou d'un second interrupteur avec la sortie d'amplificateur, les deux amplificateurs opérationnels (1, 2) opérant en alternance et en opposition mutuelle dans une phase «Autozero» ($A_1$ ou $A_2$) ou dans une phase d'amplification ($C_1$ ou $C_2$), caractérisé en ce que les amplificateurs opérationnels (1, 2) comportent chacun une première et une seconde entrée non inverseuse ainsi qu'une première et une seconde entrée inverseuse et en ce que chacun des deux amplificateurs opérationnels (1 ou 2) opèrent à la suite de sa phase «Autozero» ($A_1$ ou $A_2$) et avant le début de sa phase d'amplification ($C_1$ ou $C_2$) encore additionnellement et sans chevauchement dans une phase de préparation ($B_1$ ou $B_2$), en ce que les premières entrées non inverseuses sont respectivement reliées par l'intermédiaire d'un second pôle (8b ou 9b) du premier ou du second interrupteur avec l'entrée non inverseuse d'amplificateur (3), par l'intermédiaire d'un premier pôle (10a ou 11a) d'un troisième ou d'un quatrième interrupteur avec la sortie de l'autre amplificateur opérationnel (2 ou 1) et par l'intermédiaire d'un premier pôle (12a ou 13a) d'un cinquième ou d'un sixième interrupteur avec la masse, et les premières entrées inverseuses sont respectivement reliées par l'intermédiaire d'un troisième pôle (8c ou 9c) du premier ou du second interrupteur avec l'entrée inverseuse d'amplificateur (4), par l'intermédiaire d'un second pôle (10b ou 11b) du troisième ou du quatrième interrupteur avec la sortie de l'amplificateur opérationnel associé (1 ou 2) et par l'intermédiaire d'un second pôle (12b ou 13b) du cinquième ou du sixième interrupteur avec la masse, en ce que la seconde entrée inverseuse est reliée respectivement par l'intermédiaire d'un troisième pôle (12c ou 13c) du cinquième ou du sixième interrupteur avec la sortie de l'amplificateur opérationnel associé (1 ou 2) et est reliée à la masse par l'intermédiaire d'un condensateur (6 ou 7) associé à l'amplificateur opérationnel (1 ou 2) tandis que la seconde entrée non inverseuse est respectivement reliée directement à la masse, auquel cas il se produit temporellement successivement dans la séquence indiquée dans la suite une fermeture soit seulement du second et du cinquième interrupteur (9, 12), du second et du troisième interrupteur (9, 10), du premier et du sixième interrupteur (8, 13) ou du premier et du quatrième interrupteur (8, 11).

## Claim

1. An amplifier with a low offset voltage, including a plurality of switches, a control circuit for controlling same and two operational amplifiers whose outputs are respectively connected to the amplifier output by way of a first terminal of first and second switches respectively, wherein the two operational amplifiers (1, 2) are alternately and in push-pull relationship with each other in an «auto-zero»phase ($A_1$ and $A_2$ respectively) or in an amplification phase ($C_1$ and $C_2$ respectively) characterised in that the operational amplifiers (1, 2) each have first and second non-inverting and first and second inverting inputs and that each of the two operational amplifiers (1 and 2), following its «autozero» phase ($A_1$ and $A_2$ respectively) and before beginning its amplification phase ($C_1$ and $C_2$) is additionally non-overlappingly in a preparation phase ($B_1$ and $B_2$ respectively), that the first non-inverting inputs are respectively connected by way of a second terminal (8b and 9b) of the first and second switches respectively to the non-inverting amplifier input (3), by way of a first terminal (10a and 11a) fo third and fourth switches respectively to the output of the other operational amplifier (2 or 1 respectively) and by way of a first terminal (12a and 13a) of fifth and sixth switches respectively to earth, and the first inverting inputs are respectively connected by way of a third terminal (8c and 9c) of the first and second switches respectively to the inverting amplifier input (4), by way of a second terminal (10b and 11b) of the third and fourth switches respectively to the output of the associated operational amplifier (1 and 2) and by way of a second terminal (12b and 13b) of the fifth and sixth switches respectively to earth, that the second inverting input is respectively connected by way of a third terminal (12c and 13c) of the fifth and sixth switches respectively to the output of the associated operational amplifier (1 and 2) and it is connected to earth by way of a capacitor (6 and 7 respectively) associated with the respective operational amplifier (1 and 2) while the second non-inverting input is connected directly to earth, wherein closed in timed succession in the sequence specified hereinafter are either only the second and fifth switches (9, 12), the second and third switches (9, 10), the first and sixth switches (8, 13) or the first and fourth switches (8, 11).

Fig. 1

Fig. 2 — $U_{S,1}$, $C_1$

Fig. 3 — $U_{S,2}$, $C_2$, $C_2$

Fig. 4 — $U_{S,3}$, $B_1$

Fig. 5 — $U_{S,4}$, $B_2$

Fig. 6 — $U_{S,5}$, $A_1$, $A_1$

Fig. 7 — $U_{S,6}$, $A_2$

Fig. 8

Fig. 9

Fig. 10

## Fig. 11

## Fig. 12